# EUROPÄISCHE PATENTSCHRIFT

(11) **EP 1 665 919 B1**
(45) Veröffentlichungstag und Bekanntmachung des Hinweises auf die Patenterteilung: **09.05.2007**
(21) Anmeldenummer: 04766392.7
(22) Anmeldetag: 02.08.2004
(51) Int. Cl.: H05K 13/04

(54) **BESTÜCKKOPF ZUM BESTÜCKEN VON SUBSTRATEN MIT ELEKTRISCHEN BAUELEMENTEN**
ASSEMBLING HEAD FOR MOUNTING A SUBSTRATE WITH ELECTRIC COMPONENTS
TETE D'INSERTION POUR L'ASSEMBLAGE DE SUBSTRATS AVEC DES COMPOSANTS ELECTRIQUES

(30) Priorität: 26.09.2003 DE 10344763
(43) Veröffentlichungstag der Anmeldung: 07.06.2006
(73) Patentinhaber: SIEMENS AKTIENGESELLSCHAFT, 80333 München (DE)
(72) Erfinder: REIMANN, Günter, 81375 München (DE); TIETZE, Rosa-Maria, 85256 Vierkirchen (DE); WEINDL, Ludwig, 83064 Raubling (DE)
(86) Internationale Anmeldenummer: PCT/EP2004/051685
(87) Internationale Veröffentlichungsnummer: WO 2005/032232

(56) Entgegenhaltungen:
- EP-A- 0 749 270
- WO-A-00/19795
- US-A- 4 872 258
- US-A1- 2002 124 393

## Beschreibung

Die Erfindung bezieht sich auf einen Bestückkopf zum Bestücken von Substraten mit elektrischen Bauelementen, wobei der Bestückkopf einen Rotor mit einer Vielzahl von umlaufenden Greifereinheiten für die angesaugten Bauelemente sowie einen Stator aufweist, der eine Hubstation mit einem Hubantrieb für Greifereinheiten aufweist, die sequentiell in eine Rotorstellung verdrehbar sind, in der sie mit dem Hubantrieb in Eingriff gelangen.

Ein derartiger Bestückkopf ist z.B. durch die US 4872258 bekannt geworden, nach der die sternförmig angeordneten Greifereinheiten durch den Hubantrieb senkrecht zur Substratebene bewegbar sind. Um die Greifereinheiten in ihrer radialen Hubstellung zu sichern, greifen sie mit seitlich abstehenden Stiften in eine zirkuläre kulissenartige Führungsnut des Stators ein, wobei die Stifte an parallelen Mantelflächen der Führungsnut geführt sind. Die Führungsnut ist an der Hubstation für einen in die Führungsbahn hineinragenden, in der Hubrichtung bewegbaren Schieber unterbrochen, der ein die Führungsnut fortsetzendes Nutsegment aufweist, das in einer Übergabestellung des Hubantriebs mit der Führungsnut fluchtet. Die Stoßflächen zwischen dem Schieber und dem Stator bilden im Bereich der Mantelflächen Trennspalte, die sich quer zur Umlaufrichtung der Stifte erstrecken.

In der Handhabungstechnik ist bei Steuerkulissen es üblich, anstelle Stifte Wälzlager zu verwenden, die an den Mantelflächen abrollen, so dass die Gleitreibung vermieden wird. Bei einem herkömmlichen Revolver-Bestückkopf verläuft die Trennlinie senkrecht zur Umlaufrichtung Durch Abnutzungseffekte an den Funktionsteilen kommt es zu einer Spaltverbreiterung und zu Fluchtungsfehlern, die an den Wälzlagern schlagartige Stoßbelastungen hervorrufen, die den sicheren Halt der angesaugten Bauelemente gefährden und zu weiterer Abnutzung z.B. in Form von Rattermarken führen.

Der Erfindung liegt die Aufgabe zugrunde, die Funktionssicherheit des Bestückkopfes und zu erhöhen und die Abnutzung zu verringern.

Diese Aufgabe wird durch Erfindung gemäß Anspruch 1 gelöst. Durch den schräg zur Umlaufrichtung geneigte Trennspalt erstreckt sich die Übergangsphase des Wälzelements zwischen der Führungsnut des Stators und dem Schieber auf einen längeren Rollweg, so dass die Stoßbelastung und Abnutzung entsprechend verringert und die Lebensdauer erhöht wird.

Durch eine Weiterbildung der Erfindung nach Anspruch 2 werden diese Wirkungen nicht nur auf der Einlaufseite, sondern auch auf der Auslaufseite des Schiebers wirksam

Die Struktur nach Anspruch 3 ermöglich eine einfache Montage des Schiebers im Stator.

Durch die Weiterbildung nach Anspruch 4 ist es möglich, den Rotor in eine von der Hubstation abweichende Stellung derart zu verdrehen, dass das Wälzelemente mit seiner Berührungslinie zur Mantelfläche den Trennspalt überlappt. In dieser Stellung kann der Hubantrieb nach oben und nach unten präzise auf Anschlag verschoben werden, ohne dass es dabei zu einem Verkippen wie bei einem senkrecht verlaufenden Trennspalt kommen kann. Diese Stellungen werden von einer integrierten Messeinrichtung ermittelt und der Mittelwert daraus als Übergabestellung abgespeichert.

Ein Ausführungsbeispiel der Erfindung ist in der Zeichnung dargestellt und wird im folgenden näher erläutert. Es zeigen:
- Figur 1: eine Seitenansicht eines revolverartigen Bestückkopfes mit einem Stator und einem Rotor,
- Figur 2: den Bestückkopf nach Figur 1 in einer Stirnansicht,
- Figur 3: perspektivisch einen Teil des Stators mit einer Greifereinheit des Rotors

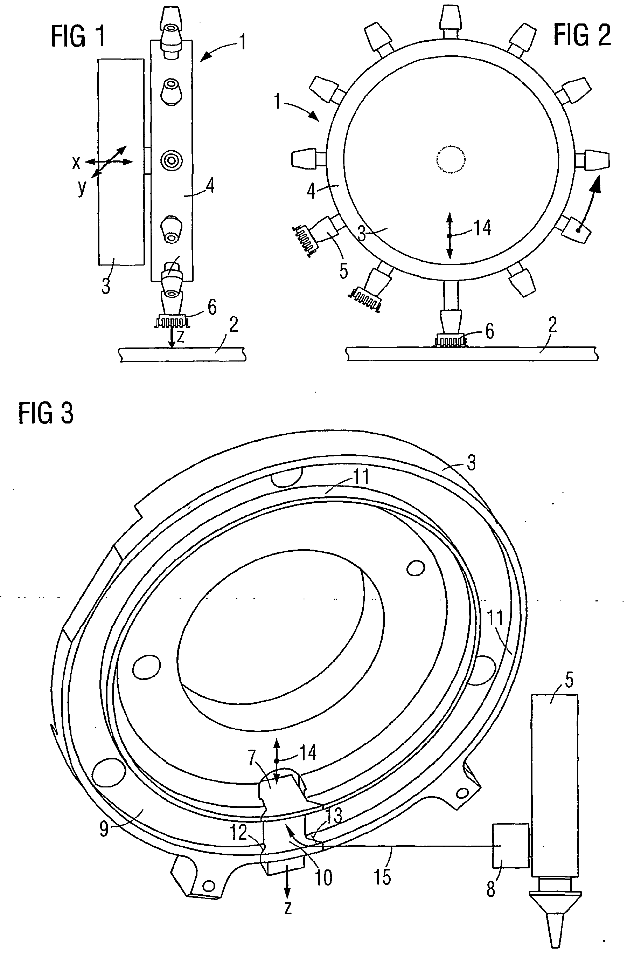

Nach den Figuren 1 und 2 ist ein revolverartiger Bestückkopf 1 in zwei Koordinatenrichtungen x und y parallel zu einem Substrat 2 verfahrbar. Der Bestückkopf weist einen Stator 3 und einen an diesem drehbar gelagerten Rotor 4 auf, der mit zirkulär angeordneten Greifereinheiten 5 für elektrische Bauelemente 6 versehen ist. Der Bestückkopf 1 ist über nicht dargestellte Zuführeinrichtungen für die Bauelemente 6 verfahrbar, wo diese von den Greifereinheiten 5 aufgenommen werden können. Danach verfährt der Bestückkopf 1 über das Substrat 2 und setzt die Bauelemente 6 durch sequentielles Absenken der Greifereinheiten 5 in einer senkrechten Hubrichtung z auf das Substrat 2 auf, wobei der Rotor 4 schrittweise derart verdreht wird, dass die Greifereinheiten 5 sequentiell in eine entsprechende Hubstation 14 gelangen. Diese ist mit einem nicht näher dargestellten elektrischen Hubantrieb für die jeweilige Greifereinheit 5 versehen, der diese in einer zum Substrat 2 senkrechten Hubrichtung z verschieben kann, um das angesaugte Bauelement 6 auf das Substrat 2 aufzusetzen.

Figur 3 zeigt einen Teil des Stators 3 mit einem Schieber 7 der Hubstation 14 und mit einer der Greifeinheiten 5. Der Schieber 7 ist in der Hubrichtung Z durch den Hubantrieb verschiebbar, der mit einer Höhenmesseinrichtung versehen ist. Die Greifereinheit 5 ist hier in der Art einer Explosionszeichnung außerhalb seiner Einbaustellung dargestellt, die durch den Bewegungspfeil 15 angedeutet ist. Die längliche Greifereinheit weist ein seitlich abstehendes Wälzelement 8 in Form eines Wälzlagers auf. Der Stator 3 ist mit einer ringförmigen, stirnseitig offenen Führungsnut 9 versehen, die in ihrer Breite dem Durchmesser des Wälzelements 8 angepasst ist. Die Wälzelemente der übrigen nicht dargestellten Greifereinheiten 5 befinden sich alle in der Führungsbahn 9 des Stators 3 und sind so während der Rotordrehung gegen radiale Verschiebung fixiert.

Im das dargestellte Wälzelement 8 befindet sich in der Hubstation 14. Der Schieber 7 ist so angeordnet, dass er in die Führungsbahn der Wälzelemente 8 hineinragt und die Führungsnut 9 unterbricht. Er ist mit einem die Führungsnut fortsetzenden Nutsegment 10 versehen, das in der gezeigten Übergabestellung mit der Führungsnut 9 fluchtet. Diese weist konzentrische, parallele Mantelflächen 11 auf, zwischen denen die Wälzelemente 8 geführt sind. Das dargestellte Wälzelement 5 greift in das Nutsegment 10 des Schiebers 3 ein.

Die Stoßflächen zwischen dem Schieber 7 und dem Stator 3 bilden im Bereich der Mantelflächen 11 Trennspalte 12, die sich schräg zur Ablaufrichtung des Wälzelements 8 erstrecken und somit einen sanften Übergang zwischen der Führungsnut 9 und dem Nutsegment 10 ermöglichen. Diese schräge Neigung ist zu beiden Seiten des Schiebers ausgebildet, so dass nicht nur der Einlauf, sondern auch der Auslauf des Wälzelementes 8 geglättet wird. Die Schräge ist so angeordnet, dass sich der Schieber 7 vom Nutgrund aus keilförmig erweitert, was seine Montage erleichtert.

Durch Verdrehen des Rotors aus der Hubstation kann die Greifereinheit 5 mit dem Wälzelement 8 in eine Stellung verdreht werden, in der sich dieses entlang einer Berührungslinie 13 mit dem schrägen Trennspalt 12 überkreuzt. In dieser Stellung ist es möglich, die genaue Hubstellung des Schiebers 7 derart zu justieren, dass die Führungsnut 9 und das Nutsegment 10 genau fluchten.

### Bezugszeichen

- 1: Bestückkopf
- 2: Substrat
- 3: Stator
- 4: Rotor
- 5: Greifereinheit
- 6: Bauelement
- 7: Schieber
- 8: Wälzelement
- 9: Führungsnut
- 10: Nutsegment
- 11: Mantelfläche
- 12: Trennspalt
- 13: Berührungslinie
- 14: Hubstation
- 15: Bewegungspfeil

## Patentansprüche

1. Bestückkopf (1) zum Bestücken von Substraten (2) mit elektrischen Bauelementen (6), wobei der Bestückkopf (1) einen Rotor (4) mit einer Vielzahl von umlaufenden Greifereinheiten (5) für die Bauelemente (6) sowie einen Stator (3) aufweist, der eine Hubstation mit einem Hubantrieb für Greifereinheiten (5) aufweist, die sequentiell in eine Rotorstellung verdrehbar sind, in der sie mit dem Hubantrieb in Eingriff gelangen, wobei die Greifereinheiten (5) durch den Hubantrieb senkrecht zu einer Substratebene bewegbar sind,
wobei die Greifereinheiten (5) mit seitlich abstehenden Wälzelementen (8) in eine zirkuläre kulissenartige Führungsnut (9) des Stators (3) eingreifen, wobei die Wälzelemente (8) an parallelen Mantelflächen (11) der Führungsnut (9) geführt sind
wobei die Führungsnut (9) in der Hubstation für einen in die Umlaufbahn der Wälzelemente (8) radial hineinragenden, in der Hubrichtung bewegbaren Schieber (7) des Hubantriebs unterbrochen ist, der ein die Führungsnut (9) fortsetzendes Nutsegment aufweist, das in einer Übergabestellung des Hubantriebs mit der Führungsnut (9) fluchtet,
und wobei Stoßflächen zwischen dem Schieber (7) und dem Stator (3) im Bereich der Mantelflächen Trennspalte (12) bilden, die sich quer zur Ablaufrichtung der Wälzelemente (8) erstrecken,
wobei zumindest einer der Trennspalte (12) zumindest partiell schräg zur Ablaufrichtung der Wälzelemente (8) geneigt verläuft.

2. Bestückkopf nach Anspruch 1,
**dadurch gekennzeichnet, dass** die Trennspalte (12) zu beiden Seiten des Schiebers (7) schräg zur Umwälzrichtung verlaufend ausgebildet ist.

3. Bestückkopf nach Anspruch 1 oder 2,
**dadurch gekennzeichnet, dass** die Trennspalte (12) eine sich vom Grund der Führungsnut (9) aus erweiternde Kontur aufweisen.

4. Bestückkopf nach Anspruch 1, 2 oder 3,
**dadurch gekennzeichnet, dass** der Rotor (4) in eine Drehstellung verdrehbar ist, in der das zylindrische Wälzelement (8) den schrägverlaufenden Trennspalt (12) überdeckt.

## Claims

1. Placement head (1) for equipping substrates (2) with electrical components (6), with the placement head (1) having a rotor (4) with a plurality of revolving gripper units (5) for the components (6) and a stator (3) which has a lift/lower station with a lift drive for gripper units (5), which can be sequentially twisted into a rotor position, in which they engage with the lift drive, with the gripper units (5) being moveable perpendicularly to the substrate level by means of the lift drive, with the gripper units (5) having laterally extending roller elements (8) which engage in a circular, crank-like guide groove (9) of the stator (3), with the roller elements (8) being guided on the parallel lateral surfaces (11) of the guide groove (9),
with the guide groove (9) in the lift/lower station being interrupted for a slider (7) of the lift drive which protrudes radially into the path of rotation of the roller elements (8) and being movable in the lift direction, the latter having a groove segment which continues the guide groove (9), said groove segment being flush with the guide groove when the lift drive is in the transfer position,
and with impact surfaces between the slider (7) and the stator (3) forming separating gaps (12) in the area of the lateral surfaces, said separating gaps extending at right angles to the direction of travel of the roller elements (8),
with at least one of the separating gaps (12) travelling at least partially at an inclined angle to the direction of travel of the roller elements (8)

2. Placement head according to claim 1,
**characterised in that**
the separating gap (12) is embodied on both sides of the slider (12) running at an angle to the direction of circulation.

3. Placement head according to claim 1 or 2,
**characterised in that**
the separating gaps (12) have a contour extending out from the base of the guide groove.

4. Placement head according to claim 1, 2 or 3,
**characterised in that**
the rotor (4) can be twisted into a rotational position, in which the cylindrical roller element (8) covers the separating gap (12), which runs at an inclined angle.

## Revendications

1. Tête d'équipement (1) pour équiper des substrats (2) avec des composants (6) électriques, la tête d'équipement (1) présentant un rotor (4) avec une pluralité d'unités préhensibles (5) rotatives pour les composants (6) et un stator (3), qui présente un poste de levage avec un entraînement de levage pour des unités préhensibles (5), qui peuvent être tournées de façon séquentielle dans une position de rotor, dans laquelle elles viennent en prise avec l'entraînement de levage, les unités préhensibles (5) étant déplaçables par l'entraînement de levage perpendiculairement à un plan de substrat, les unités préhensibles (5) s'engageant avec des éléments de roulement (8) dépassant latéralement dans une rainure de guidage (9) en forme de coulisse circulaire du stator (3), les éléments de roulement (8) étant guidés sur des surfaces d'enveloppe (11) parallèles de la rainure de guidage (9), la rainure de guidage (9) étant interrompue au poste de levage pour un coulisseau (7), dépassant radialement dans la trajectoire des éléments de roulement (8) et mobile dans le sens de levage, de l'entraînement de levage, qui présente un segment de rainure prolongeant la rainure de guidage (9), lequel est aligné dans une position de transfert de l'entraînement de levage avec la rainure de guidage (9), et des surfaces d'about entre le coulisseau (7) et le stator (3) formant dans la zone des surfaces d'enveloppe des fentes de séparation (12) qui s'étendent transversalement au sens de déroulement des éléments de roulement (8), au moins l'une des fentes de séparation (12) étant agencée inclinée au moins partiellement en biais par rapport au sens de déroulement des éléments de roulement (8).

2. Tête d'équipement selon la revendication 1, **caractérisée en ce que** la fente de séparation (12) est réalisée des deux côtés du coulisseau (7) en biais par rapport au sens de circulation.

3. Tête d'équipement selon la revendication 1 ou 2, **caractérisée en ce que** la fente de séparation (12) présente un contour s'élargissant à partir du fond de la rainure de guidage (9).

4. Tête d'équipement selon la revendication 1, 2 ou 3, **caractérisée en ce que** le rotor (4) peut être tourné dans une position de rotation dans laquelle l'élément de roulement (8) cylindrique recouvre la fente de séparation (12) agencée en biais.
